# EUROPÄISCHE PATENTSCHRIFT

(11) **EP 0 902 982 B1**
(45) Veröffentlichungstag und Bekanntmachung des Hinweises auf die Patenterteilung: **02.10.2002**
(21) Anmeldenummer: 97925853.0
(22) Anmeldetag: 20.05.1997
(51) Int. Cl.: H01L 31/115, H01L 31/118

(54) **STREIFENDETEKTOR**
STRIP DETECTOR
DETECTEUR A BANDES

(30) Priorität: 20.05.1996 DE 19620081
(43) Veröffentlichungstag der Anmeldung: 24.03.1999
(73) Patentinhaber: Max-Planck-Gesellschaft zur Förderung der Wissenschaften e.V., 80539 München (DE); KEMMER, Josef, Dr., D-85764 Oberschleissheim (DE)
(72) Erfinder: KEMMER, Josef, D-85764 Oberschlei heim (DE); LUTZ, Gerhard, D-81739 München (DE); RICHTER, Rainer, D-81243 München (DE); STRÜDER, Lothar, D-80803 München (DE); ANDRICEK, Ladislav, D-80801 München (DE); GEBHART, Thomas, D-82418 Murnau (DE)
(74) Vertreter: Münich, Wilhelm, Dr.
(86) Internationale Anmeldenummer: DE9701015
(87) Internationale Veröffentlichungsnummer: WO97044831

(56) Entgegenhaltungen:
- US-A- 4 442 592
- NUCLEAR INSTRUMENTS & METHODS IN PHYSICS RESEARCH, SECTION - A: ACCELERATORS, SPECTROMETERS, DETECTORS AND ASSOCIATED EQUIPMENT, Bd. A277, Nr. 1, SECTION A, 15.April 1989, Seiten 147-153, XP000110255 BATIGNANI G ET AL: "DOUBLE-SIDED READOUT SILICON STRIP DETECTORS FOR THE ALEPH MINIVERTEX"
- NEW DEVELOPMENTS IN RADIATION DETECTORS. SEVENTH EUROPEAN SYMPOSIUM ON SEMICONDUCTOR DETECTORS, SCHLOSS ELMAU, GERMANY, 7-10 MAY 1996, Bd. 377, Nr. 2-3, ISSN 0168-9002, NUCLEAR INSTRUMENTS & METHODS IN PHYSICS RESEARCH, SECTION A (ACCELERATORS, SPECTROMETERS, DETECTORS AND ASSOCIATED EQUIPMENT), 1 AUG. 1996, ELSEVIER, NETHERLANDS, Seiten 412-421, XP004008288 RICHTER R H ET AL: "Strip detector design for ATLAS and HERA-B using two-dimensional device simulation"
- NUCLEAR INSTRUMENTS & METHODS IN PHYSICS RESEARCH, SECTION - A: ACCELERATORS, SPECTROMETERS, DETECTORS AND ASSOCIATED EQUIPMENT, Bd. A326, Nr. 1 / 02, 1.März 1993, Seiten 209-213, XP000367565 KEMMER J ET AL: "CONCEPTS FOR SIMPLIFICATION OF STRIP DETECTOR DESIGN AND PRODUCTION" in der Anmeldung erwähnt

## Beschreibung

### Technisches Gebiet

Die Erfindung bezieht sich auf einen Streifendetektor zum Nachweis ionisierender Teilchen und/oder Strahlung sowie ein zur Hestelllung des Detekors gerichtetes Verfahren. Der Streifendetektor weist ein Siliziumsubstrat auf, das wenigstens an einer Substratoberfläche als Streifen und Spannungszuführungsgebiete gegenseitig beabstandete, n-dotierte Bereiche sowie zwischen den n-dotierten Bereichen einen p-dotierten Isolationsbereich vorsieht. Ferner weist der Detektor auf einer Substratoberfläche eine erste Isolatorschicht sowie Metallstreifen auf, die oberhalb der n-dotierten Bereiche angeordnet sind.

### Stand der Technik

Silziumstreifenzähler dienen dem Nachweis ionisiernder Teilchen und Strahlung innerhalb von physikalischen Experimenten und anderer Detektoren. Das Funktionsprinzip beruht auf streifenförmig angeordneten Dioden, wobei die Streifen kapazitiv gekoppelt oder direkt an ladungsempfindliche Verstärker angeschlossen werden. Der Abstand der Streifen und ihre Breite definieren zusammen mit der Wahl des Auslesemodus die Ortsauflösung des Detektors. Das Halbleitersubstrat ist sehr hochohmig, so daß mit moderaten Spannungen der gesamte Silizium-Wafer in seiner Dicke depletiert werden kann. Dadurch erhält man eine große Konvertierungslänge für die einfallenden Teilchen oder Strahlung und somit ein hohes Signal bei relativ kleiner Detektorkapazität.

Das Halbleitersubstrat kann schwach n- oder p-dotiert sein. Die Streifen selbst bestehen üblicherweise aus hoch dotierten Gebieten. Sie können entweder p- oder n-dotiert sein, wobei die rückseitige großflächige Elektrode vom jeweilig entgegengesetzten Dotierungstyp sein muß. Bei doppelseitigen Streifenzählern befinden sich auf den beiden Seiten Streifen entgegengesetzten Dotierungstyps. Durch eine Neigung der Streifen beider Seiten zueinander erhält man eine Ortsauflösung in x-und in y-Richtung.

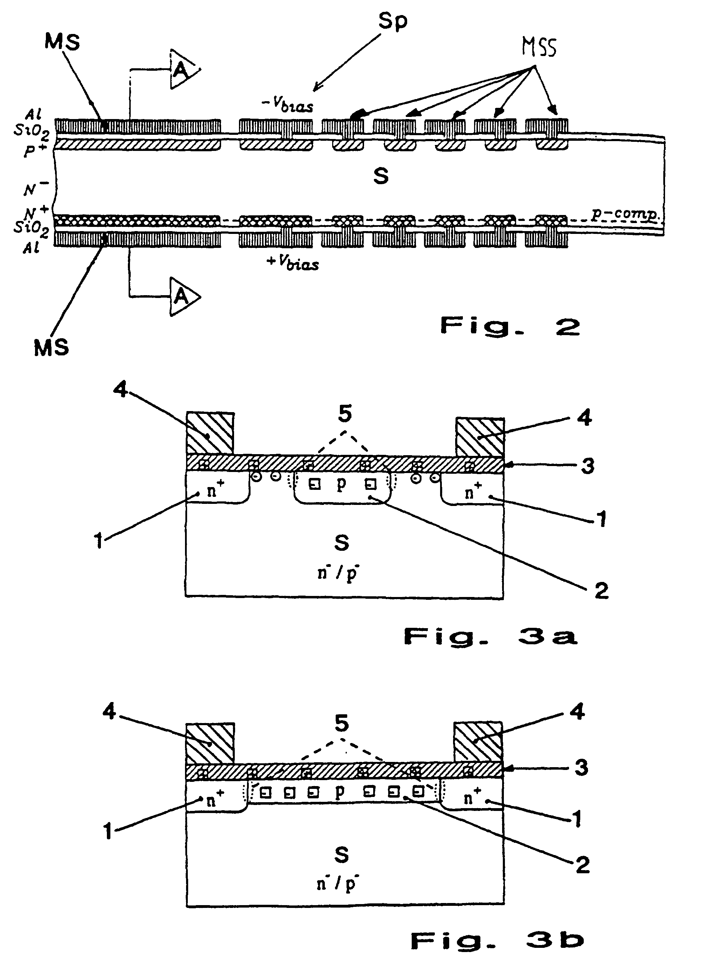

Eine weitere Unterscheidungsmöglichkeit für Streifenzähler besteht in der Art der Signalauskopplung zur Ausleseelektronik. Bei der einfachen Form werden die streifenförmig angeordneten Dioden direkt oder über extern zwischengeschaltete Kondensatoren an die Eingänge der elektronischen Verstärker angeschlossen. Man nennt sie deshalb direkt gekoppelte Streifenzähler. Beim kapazitiv gekoppelten Streifenzähler werden die Kondensatoren in den Streifenzähler integriert. Dazu wird der Kondensator genutzt, der durch das hochdotierte streifenförmige Gebiet, einer Isolatorschicht als Dielektrikum (z.B. Siliziumoxyd) und einem Metallstreifen gebildet wird. Ein derartiger typischer kapazitiv gekoppelter Streifenzähler ist als Stand der Technik in Figur 2 dargestellt.

Die elektrische Isolation erfolgt bei p-dotierten Streifen, wie sie an der oberen Substratoberfläche als schräg schraffierte Gebiete in Figur 2 eingezeichnet sind, durch positive Oxydladungen, die im wesentlichen an der Grenzfläche zwischen dem Substratmaterial Silizium - in dem Ausführungsbeispiel gemäß Figur 2 ist das Substratmaterial n--dotiert - und dem als Isolatorschicht dienenden Siliziumdioxyd (SiO2) fixiert sind und während der Oxydation selbst entstehen. Dadurch wird die Ausbildung von parasitären Löcherkanälen, die die Streifen kurzschließen würden, unterdrückt. Der in Figur 2 auf zwei gegenüberliegende Seiten prozessierte Streifendetektor weist zum Signalabgriff Metallstreifen MS auf, die jeweils oberhalb entsprechend dotierter Bereiche angeordnet sind. Mit den Metallstreifen sind Verstärker A verbunden. Zur Spanungsversorgung und Aufrechterhaltung entsprechender elektrischer Felder innerhalb der Detektorstruktur sind Spannungszuführungskontakte Sp vorgesehen über die die Bias-Spannung ±Vbias angelegt wird.

Wenn z.B. in doppelseitigen Detektoren auch n-Streifen verwendet werden - wie es in der Darstellung gemäß Figur 2 untere Substratoberfläche der Fall ist -, influenziert die o. g. positive Oxydladung im Bereich zwischen den n-dotierten Gebieten, d.h in den n-Streifen unterhalb der Kontakte MS sowie in den die Versorgungsspannung führenden Gebieten und Zwischenringe MSS am Detektorrand, die die Versorgungsspannung hin zum Detektorrand abbauen, eine Elektronenschicht, die die n-Gebiete kurzschließen würde. Um das zu verhindern wird die Detektoroberfläche in den Zwischengebieten p-dotiert (p-comp.).

Hierbei haben sich zwei Varianten durchgesetzt. Die p-Schicht kann durch eine während der Implantation aufliegende Lackmaske auf die Regionen zwischen den n-Schichten begrenzt bleiben. Das Verfahren wird in der englischsprachigen Literatur als "Blocking isolation" bezeichnet. Diese Technik ist in folgenden Beiträgen bereits beschrieben: J. Sedlmeir, Diplomarbeit TU München, 1985 und G. Lutz et al. MPI-PAE/Exp. El. 175, 1987 sowie G. Lutz, S 195, New York:Plenum, 1988. Hierzu ist in Figur 3a ein Detektorausschnitt dargestellt, der in der Substratoberfläche n+-dotierte Bereiche 1 vorsieht, in deren Zwischenraum zur Vermeidung von Kurzschlüssen ein isoliertes p-Gebiet 2 implantiert ist. Unmittelbar auf der Substratoberfläche ist eine Isolatorschicht 3, bspw. Siliziumoxid, aufgebracht, in der die Oxydladungen enthalten sind. Oberhalb der n+dotierten Bereiche 1 sind Metallstreifen 4 zur Signalabnahme vorgesehen.

Die andere Möglichkeit ist die p-Schicht 2 ohne jegliche Maske zu implantieren, wobei sie durch die höher dotierten n-Gebiete 1 überkompensiert wird (siehe hierzu im folgenden Fig. 3b, in der die gleichen Bezugszeichen verwandt werden wie in Figur 3a). Sie wird "Spray isolation" genannt und ist beispielweise in einem Artikel von J. Kemmer und G. Lutz in Nucl. Instr. and Meth. A 326, S. 209, 1993 beschrieben.

Beide Möglichkeiten haben Vor- und Nachteile.

Entsprechend ihrer Aufgabe werden Streifendetektoren häufig in einer strahlenbelasteten Umgebung eingesetzt. Ionisierende Strahlung und hochenergetische Teilchen schädigen jedoch das Halbleitermaterial, so daß die Eigenschaften des Detektors mit der Zeit degradieren.

Zwei Arten der Schädigung können grob unterschieden werden.

Eine Bestrahlung der Detektoroberfläche verursacht eine Zunahme der Defekte im Bereich der Grenzfläche zwischen dem Silizium und dem SiO2 und damit eine Erhöhung der Oxydladungen. Dieser Effekt setzt schon bei relativ niedrigen Bestrahlungsdosen ein. Die Größe der generierten Oxydladungen sättigt sich jedoch bei höheren Dosen. Auch im Silizium selbst entstehen bei der Bestrahlung mit Teilchen Defekte. Im Halbleitersubstrat bewirkt die Strahlung einen stark erhöhten Leckstrom und eine Veränderung der Dotierung. Dabei wechselt der Dotierungstyp des Halbleiters von n nach p (Typinversion), wodurch eine vollständig neue Feldverteilung innerhalb des Bauelementes entsteht. Diese effektive p-Dotierung steigt während der Bestrahlung weiter an und führt zu stark erhöhten Verarmungsspannungen und damit zu höheren Betriebsspannungen.

Beide Schädigungsarten, die Erhöhung der Oxydladungen und die Inversion der Dotierung zum p-Typ, bewirken bei der "Blocking isolation" eine Erhöhung der elektrischen Feldstärke in dem in Fig. 3a gekennzeichneten Bereich 5. Das bedeutet, daß die Durchbruchspannung mit zunehmender Bestrahlung kleiner wird. Damit besteht ein Konflikt zwischen der erforderlichen Erhöhung der Betriebsspannung und der verringerten Durchbruchspannung.

Ein weiteres Problem besteht darin, daß Spezifikation und Tests zwangsläufig unbestrahlte Detektoren betreffen. Da sich das Durchbruchverhalten aber während des Betriebes verschlechtert, kann aus Messungen am unbestrahlten Bauelement keine sichere Aussage über die Eignung des gemessenen Detektors getroffen werden. Hinzu kommt, daß in einem System die Auswechslung von defekten Detektoren wegen der komplizierten Montagetechniken häufig sehr kostenaufwendig ist. Bei der "Spray isolation" tritt dieses Problem nicht auf. Das Maximum des elektrischen Feldes liegt hier direkt am Übergang zwischen dem n-Gebiet und dem p-Isolationsgebiet. Siehe hierzu die Bereiche 5 in Figur 3b. Die Höhe dieses Maximums wird durch den Konzentrationsunterschied und die Steilheit des pn-Übergangs (Dotierungsgradient) sowie durch die anliegende Spannung bestimmt. Mit der Bestrahlung und der damit verbundenen Erhöhung der Oxydladung wird ein Teil der p-Dotierung (negative Akzeptorrümpfe) durch die positive Oxydladung kompensiert, und das laterale elektrische Feld verringert sich.

Die Durchbruchspannung erhöht sich mit steigender Oxydladungsdichte. Im unbestrahlten Detektor treten die höchsten elektrischen Felder auf, so daß auch die ungünstigsten Verhältnisse testbar sind. Das Problem bei dieser Isolationsstruktur liegt in der geeigneten Wahl der Dotierungskonzentration, die hoch so sein muß, daß die zu erwartende Oxydladungserhöhung kompensiert werden darf kann aber andererseits nicht so hoch sein, daß die Durchbruchspannung von vornherein zu niedrig ist. Der Sättigungswert für die Oxydladungsdichte, nach dem die Dotierungskonzentration ausgerichtet werden muß, hängt von dem elektrischen Feld im Oxyd während der Bestrahlung und vermutlich von der Qualität des SiO2 im Ausgangszustand also von der Prozessierung ab. Da es nicht genau absehbar ist, welcher Sättigungswert sich einstellt, sollte die Dotierungskonzentration mit ausreichender Sicherheitsreserve eingestellt werden, was das Problem zusätzlich verschärft.

Zusammenfassend kann gesagt werden, daß derzeit keine n-Seitenisolationstruktur existiert, die allen Anforderungen in bestrahlten Detektoren genügt.

Als sehr kostentreibend wirkt sich gerade bei der Produktion kapazitiv gekoppelter Streifenzähler die Forderung nach einer hohen Streifenausbeute aus. Die Vielzahl der Streifen und die Größe der Detektoren (bis zu 40cm2) führen dazu, daß oft eine beträchtliche Anzahl der Streifen einen Kurzschluß zu den darunter liegenden implantierten Streifen haben, wodurch entweder der Kanal nicht mehr auslesbar ist, oder ein Strom aus der Elektronik in den Detektor injiziert wird. Diese Kurzschlüsse entstehen durch Löcher in der Isolatorschicht, die hauptsächlich durch eine unzulängliche Maskierung während des Ätzens dieser Isolatorschicht bei der Kontaktfensteröffnung entstehen. Man behilft sich mit dem Aufbringen einer zweiten Isolatorschicht, die in einem zweiten lithographischen Schritt strukturiert wird. Dabei wird der Umstand ausgenutzt, daß eine Koinzidenz von Defekten in beiden Isolatorschichten an einem Ort sehr unwahrscheinlich ist. Nachteilig an diesem Doppelisolatorverfahren ist der erforderliche Einsatz des zusätzlichen lithographischen Schrittes, der die Produktionskosten seinerseits wieder erhöht, ohne daß ein Performance-Gewinn erzielt wird.

### Darstellung der Erfindung

Der Erfindung liegt die Aufgabe zugrunde einen Streifendetekor gemäß dem Oberbegriff des Anspruch 1 derart weiterzubilden, daß die vorstehend genannten Nachteile die mit dem Spannungsdurchbruchverhalten zusammenhängen weitgehend ausgeschlossen werden können. Ferner sollen die Haltbarkeit gesteigert und die Herstellungskosten reduziert werden. Insbesondere sollen Siliziumstreifenzähler mit n-dotierten Streifen bei hohen Spannungen in strahlenbelasteter Umgebung betrieben und mit größerer Ausbeute gefertigt werden.

Erfindungsgemäß wird ein Streifendetektor zum Nachweis ionisierender Teilchen und/oder Strahlung, mit einem Siliziumsubstrat, das wenigstens an einer Substratoberfläche als Streifen und Spannungszuführungsgebiete gegenseitig beabstandete, n-dotierte Bereiche sowie zwischen den n-dotierten Bereichen einen p-dotierten Isolationsbereich vorsieht, einer auf einer Substratoberfläche aufgebrachten ersten Isolatorschicht sowie Metallstreifen, die oberhalb der n-dotierten Bereiche angeordnet sind, derart weitergebildet, daß unmittelbar über der ersten Isolatorschicht wenigstens eine weitere Isolatorschicht vorgesehen ist, und daß wenigstens eine der Isolatorschichten in Projektion über dem Zwischenbereich zweier benachbarter n-dotierter Bereiche unterbrochen ist, und daß das p-dotierte Isolationsgebiet eine laterale p-Dotierstoffkonzentrationsverteilung aufweist, die im Bereich unterhalb der Unterbrechung der unterbrochenen Isolatorschicht eine höhere Dotierstoffkonzentration vorsieht, als in den unmittelbar an den n-dotierten Bereichen angrenzenden Isolationsbereichen.

Das Wesen der Erfindung besteht in der räumlichen Aufteilung der maximalen elektrischen Feldstärke im Übergangsbereich zwischen den hochdotierten n-Gebieten und den p-Isolationsgebieten, wobei die Produktion dieser Detektoren kostengünstig erfolgen kann.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Querschnittsdarstellung durch einen erfindungsgemäß ausgebildeten Streifendetektor,
- Fig. 2: doppelseitig strukturierter bekannter Streifendetektor und
- Fig. 3 a,b: bekannte Streifendetektor hergestellt mit "Blocking isolation" (Fig. 3a) und "Spraying isolation" (Fig. 3b).

In den folgenden Figuren sind jeweils gleiche oder entsprechende Teile mit den selben Bezugszeichen bezeichnet, so daß auf eine erneute Vorstellung verzichtet wird.

Die Figuren 2 und 3 a, b sind vorstehend zum Stand der Technik bereits beschrieben worden, so daß im folgenden nicht mehr darauf eingegangen wird.

Die Erfindung wird anhand von eines Ausführungsbeispiels erläutert. Dabei wird zuerst der jeweilige technologische Prozeß beschrieben, der zu der erfindungsgemäßen Struktur führt. Im Anschluß werden die Eigenschaften der Struktur in Zusammenhang mit der vorteilhaften Prozeßführung diskutiert.

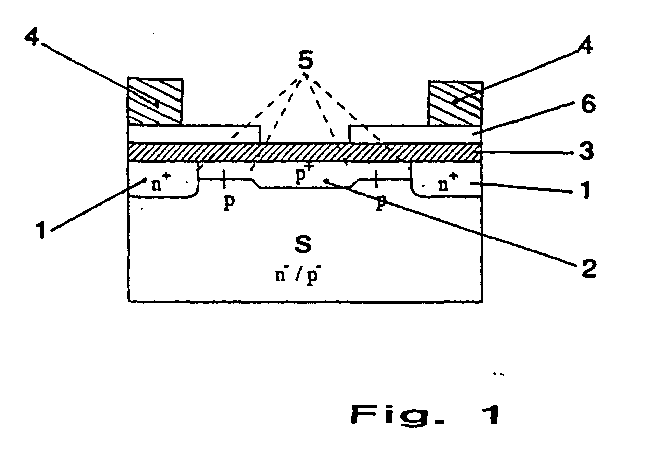

Die Prozessierung des in Figur 1 dargestellten Streifendetektors beginnt mit der thermischen Oxydation des Siliziumsubstrates S, das um eine große Raumladungszonenausdehnung zu ermöglichen, nur sehr gering dotiert sein darf. Der spezifische Widerstand des Siliziumsubstrates S sollte im Bereich von 1kOhmcm oder höher liegen. Dabei ist es für die Erfindung unwesentlich, ob das Halbleitersubstrat S schwach n-dotiert oder schwach p-dotiert ist. Die Dicke der aufgewachsenen Oxydschicht 2 (1.Isolatorschicht) kann im Bereich von 200nm liegen. Beträchtliche Abweichungen von diesem Wert sind durchaus möglich. Nach der Oxydation erfolgt das Aufbringen einer Lackmaske, die in den Bereichen der nachfolgend zu implantierenden Gebiete geöffnet wird. Vorteilhaft ist es, das Oxyd 2 im Bereich der geöffneten Lackmaske anzuätzen, um Marken für die Justage der darauffolgenden lithographischen Masken zu erzeugen. Die Implantation der n-Gebiete 1 erfolgt mit einer relativ hohen Dosis im Bereich von 1015cm-2 und einer Implantationsenergie, die so eingestellt werden muß, daß ein wesentlicher Teil der implantierten Ionen das Siliziumoxyd 2 durchdringt. Bei der gewählten Schichtdicke und der Verwendung von Phosphor liegt diese Energie im Bereich von 180keV. Nach der Implantation kann eine thermische Behandlung erfolgen, um den Implanten elektrisch zu aktivieren und eine Eindiffusion des Dotierstoffes zu erreichen. Anschließend wird eine Siliziumnitridschicht 6 (2. Isolatorschicht) mit einer Dicke von ca. 100nm abgeschieden. Diese Schicht wird so strukturiert, daß Öffnungen im Kontaktbereich des später aufzubringenden Metalls zu den n-dotierten Bereichen und in den Gebieten zwischen den n-dotierten Bereichen, die zueinander isoliert werden sollen, entstehen.

Als nächster Schritt erfolgt die Implantation des p-Isolationsgebietes 2 mit Borionen. Die Implantationsparameter (Energie und Dosis) sind so einzustellen, daß im Bereich der geöffneten Siliziumnitridschicht 6 eine merklich höhere Bordosis in das Silizium S implantiert wird als im abgedeckten Bereich (Vorschlag für die Implantationsparameter bei den vorliegenden Schichtdicken: Energie 80keV, Dosis 7x1012cm-2).

Abschließend erfolgen die Öffnung der Kontaktfenster im Siliziumoxyd 2 (nicht dargestellt) und die Metallisierung mit Aluminium und deren Strukturierung.

Das Aufbringen einer zweiten Leitbahnebene und/oder einer Passivierungsschicht sind optional. Durch die abgestufte Bordosis im Silizium S können die elektrischen Felder im Übergangsbereich 5 zwischen dem n-dotierten Bereich 1 und der p-Isolationsschicht 2 niedrig gehalten werden und gleichzeitig im mittleren Bereich die Dosis so erhöht werden, daß eine sichere Isolation der n-Schichten 1 auch nach der Erhöhung der Oxydladungen gewährleistet ist. Diese erfindungsgemäße Technologie erfordert gegenüber dem im Stand der Technik vorgestellten Doppelisolatorverfahren keinen weiteren technologischen Mehraufwand. Die Kontaktfensteröffnung im Siliziumoxyd kann vorgezogen werden und z.B. gleich nach der thermischen Oxydation erfolgen.

Selbstverständlich kann die erfindungsgemäße Ausbildung des Streifendetektors auch für direkt gekoppelte Streifenzähler angewendet werden. In diesem Fall ist das Doppelisolatorverfahren für die Erhöhung der Streifenausbeute jedoch nicht erforderlich, da die Verbesserung des Durchbruchverhaltens davon unberührt bleibt.

Auch zur Isolation von Schutzringen - siehe hierzu den Beitrag von A. Bischof et. al., erschienen in Nucl. Instr. and Meth. A326, Seite 27, 1993 -, die die hohe Betriebsspannung zum Rand des Detektors hin allmählich abbauen, ist die erfindungsgemäße Isolationsstruktur geeignet. Sie isoliert um den gesamten Detektor verlaufende benachbarte Ringe gegeneinander, so daß sich auf ihnen unterschiedliche Potentiale bei geringen elektrischen Feldstärken ausbilden können. An den Stirnseiten der implantierten Streifen befinden sich bei einigen Ausführungen von Streifenzählern Bias-Strukturen, die unter Ausnutzung des Punch-Through-Effektes die Spannung von den Spannungszuführungsgebieten auf die Streifen übertragen. Dieser Bias-Mechanismus ist auch bei n-dotierten Streifen einsetzbar. Die Isolation an der Oberfläche kann auch durch erfindungsgemäße Isolationsstrukturen erfolgen. Damit wird eine einfache technologie-kompatible Lösung für die Isolation aller für den Betrieb eines n-Seiten-Streifenzählers erforderlichen Strukturen, wie beispielsweise Streifen, Bias-Strukturen und Schutzringe, zur Verfügung gestellt.

## Patentansprüche

1. Streifendetektor zum Nachweis ionisierender Teilchen und/oder Strahlung, mit einem Siliziumsubstrat(s), das wenigstens an einer Substratoberfläche als Streifen und Spannungszuführungsgebiete gegenseitig beabstandete, n-dotierte Bereiche (1) sowie zwischen den n-dotierten Bereichen einen p-dotierten Isolationsbereich (2) vorsieht, einer auf einer Substratoberfläche aufgebrachten ersten Isolatorschicht (3) sowie Metallstreifen (4), die oberhalb der n-dotierten Bereiche angeordnet sind,
**dadurch gekennzeichnet, daß** unmittelbar über der ersten Isolatorschicht (3) wenigstens eine weitere Isolatorschicht (6) vorgesehen ist, und daß wenigstens eine der Isolatorschichten in Projektion über dem Zwischenbereich zweier benachbarter n-dotierter Bereiche unterbrochen ist, und
daß das p-dotierte Isolationsgebiet (2) eine laterale p-Dotierstoffkonzentrationsverteilung aufweist, die im Bereich unterhalb der Unterbrechung der unterbrochenen Isolatorschicht eine höhere Dotierstoffkonzentration vorsieht, als in den unmittelbar an den n-dotierten Bereichen angrenzenden Isolationsbereichen.

2. Streifendetektor nach Anspruch 1,
**dadurch gekennzeichnet, daß** die Unterbrechung in der Isolatorschicht mittig über dem Zwischenbereich derart angeordnet ist, daß die unterbrochene Isolatorschicht Seitenbereiche des Zwischenbereiches überdeckt.

3. Streifendetektor nach Anspruch 1 oder 2,
**dadurch gekennzeichnet, daß** wenigstens ein Metallstreifen durch einen Kontakt mit n-dotierten Bereichen verbunden ist.

4. Streifendetektor nach einem der Ansprüche 1 bis 3,
**dadurch gekennzeichnet, daß** wenigsten ein Metallstreifen durch mindestens eine der Isolatorschichten von n-dotierten Bereichen isoliert ist.

5. Streifendetektor nach einem der Ansprüche 1 bis 4,
**dadurch gekennzeichnet, daß** die p-Dotierstoffkonzentration in den unmittelbar an den n-dotierten Bereichen angrenzenden Isolationsbereichen auch in den n-dotierten Bereichen vorhanden ist, jedoch von der höheren n-Dotierstoffkonzentration überkompensiert wird.

6. Streifendetektor nach einem der Ansprüche 1 bis 5,
**dadurch gekennzeichnet, daß** die erste Isolatorschicht aus Siliziumoxid besteht.

7. Streifendetektoranordnung nach einem der Ansprüche 1 bis 6,
**dadurch gekennzeichnet, daß** mindestens eine der weiteren Isolatorschichten aus einem anderen Material, vorzugsweise Siliziumnitrid, als die erste Isolatorschicht besteht.

8. Verfahren zur Herstellung eines Streifendetektors nach Anspruch 1,
**gekennzeichnet durch** folgende Verfahrensschritte:
- Erzeugung einer elektrisch isolierenden Oxidschicht (3) auf einer Siliziumsubstratoberfläche,
- Einbringen von n-Dotierstoffatomen in die Siliziumsubstratoberfläche mittels Ionenimplantation zur Bildung der gegenseitig beabstandeten n-dotierten Bereiche (1),
- ganzflächiges Abscheiden einer zweiten elektrisch isolierenden Schicht (6) auf der Oxidschicht,
- lokale Abtragung der zweiten elektrisch isolierenden Schicht an Stellen zwischen n-dotierten Bereichen sowie an n-dotierten Bereichen, die der Spannungszuführung dienen,
- homogene, großflächige Implantation mit p-Dotierstoffatomen,
- lokale Abtragung der Oxidschicht an n-dotierten Bereichen, die der Spannungszuführung dienen,
- homogene, ganzflächige Metallisierung und
- Strukturierung der Metallschicht zur Herausbildung von Metallstreifen.

9. Verfahren nach Anspruch 8,
**dadurch gekennzeichnet, daß** die Oxidshcicht durch thermische Oxidation gebildet wird.

10. Verfahren nach Anspruch 8 oder 9,
**dadurch gekennzeichnet, daß** die n-dotierten Bereiche mit Phosphor unter Verwendung einer Maske dotiert werden.

11. Verfahren nach einem der Ansprüche 8 bis 10,
**dadurch gekennzeichnet, daß** die zweiten elektrisch isolierende Schicht aus Siliziumnitrid besteht.

12. Vefahren nach einem der Ansprüche 8 bis 11,
**dadurch gekennzeichnet, daß** die lokale Abtragung der zweiten elektrisch isolierenden Schicht mittels Ätzens und unter Verwendung einer Maske erfolgt.

13. Verfahren nach einem der Ansprüche 8 bis 12,
**dadurch gekennzeichnet, daß** die Metallisierung mit Aluminium durchgeführt wird.

14. Verfahren nach einem der Ansprüch 8 bis 13,
**dadurch gekennzeichnet, daß** die Strukturierung der Metallschicht mittels Ätzens und unter Verwendung einer Maske durchgeführt wird.

## Claims

1. Stripe detector for detecting ionising particles and/or radiation, comprising a silicon substrate (S) providing mutually spaced n-doped zones (1) as well as a p-doped isolating zone (2) between said n-doped zones, as stripes and voltage feeder areas on at least one substrate surface, a first insulator layer (3) applied on one substrate surface as well as metal strips (4) disposed above said n-doped areas,
**characterised in that** at least one further isolator layer (6) is provided directly above said first isolator layer (3), and that at least one of said isolator layers presents a discontinuity in projection above the intermediate zone between two adjacent n-doped areas, and
that said p-doped isolation area (2) presents a lateral p-type doping agent concentration distribution that provides a higher doping agent concentration in the area underneath said discontinuity of said discontinuous isolation layer than in the isolation areas directly adjacent to said n-doped areas

2. Stripe detector according to Claim 1,
**characterised in that** said discontinuity in said isolator layer is centrally disposed above said intermediate area in such a way that the discontinuous isolator layer covers lateral areas of said intermediate area.

3. Stripe detector according to Claims 1 and 2,
**characterised in that** at least one metal strip is connected by means of a contact to n-doped areas.

4. Stripe detector according to any of the Claims 1 to 3,
**characterised in that** at least one metal strip is isolated from n-doped areas by means of at least one of said isolator layers.

5. Stripe detector according to any of the Claims 1 to 4,
**characterised in that** the p-type doping agent concentration in the isolation areas directly adjacent to said n-doped areas is present also in the n-doped areas whilst it is overcompensated, however, by the higher n-type doping agent concentration.

6. Stripe detector according to any of the Claims 1 to 5,
**characterised in that** said first isolator layer consists of silicon oxide.

7. Stripe detector according to any of the Claims 1 to 5,
**characterised in that** at least one of said further isolator layers consists of a material different from the material of said first isolator layer, preferably of silicon nitride.

8. Method of manufacturing a stripe detector according to Claim 1,
**characterised by** the following steps:
- producing an electrically insulating oxide layer (3) on a silicon substrate surface,
- introducing n-type doping agent atoms into said silicon substrate surface by way of ion implantation for forming said mutually spaced n-doped areas (1),
- depositing a second electrically insulating layer (6) over the entire surface on said oxide layer,
- local removal of said second electrically insulating layer at sites between n-doped areas as well as on n-doped areas serving as voltage feeders,
- homogeneous large-area implantation with p-type doping agent atoms,
- local removal of said oxide layer at n-doped areas serving as voltage feeders,
- homogeneous metallization over the entire surface, and
- structuring said metal layer for forming metal strips.

9. Method according to Claim 8,
**characterised in that** said oxide layer is formed by thermal oxidation.

10. Method according to Claim 8 or 9,
**characterised in that** said n-doped areas are doped with phosphorous, using a mask.

11. Method according to any of the Claims 8 to 10,
**characterised in that** said second electrically insulating layer consists of silicon nitride.

12. Method according to any of the Claims 8 to 11,
**characterised in that** said local removal of said second electrically insulating layer is carried out by means of etching with the use of a mask.

13. Method according to any of the Claims 8 to 12,
**characterised in that** said metallization operation is carried out with aluminium.

14. Method according to any of the Claims 8 to 13,
**characterised in that** said operation of structuring said metal layer is carried out by means of etching with the use of a mask.

## Revendications

1. Détecteur de bandes à détecter des particules de ionisation et/ou du rayonnement, comprenant un substrat en silicium (S), qui fournit des aires dopée en n (1) espacées l'une de l'autre, ainsi qu'une aire isolante dopée en p (2) entre lesdites aires dopées en n, comme bandes et aires d'amenée de tension sur au moins une surface du substrat, ainsi qu'une première couche isolante (3) appliquée sur une surface du substrat, et des lames de métal (4) disposées au-dessus desdites aires dopées en n,
**caractérisé en ce qu'**au moins une couche isolante (6) additionnelle est formée directement au-dessus de ladite première couche isolante (3), et qu'au moins une desdites couches isolantes présente une rupture en projection au-dessus de l'aire intermédiaire entre deux aires dopées en n adjacentes, et
**en ce que** ladite aire dopée en n isolante (2) présente une distribution latérale de la concentration du dope type p d'une manière, qui fournit une concentration du dope dans l'aire au-dessous de ladite rupture de ladite couche isolante interrompue, qui est plus haute que la concentration dans les aires isolantes directement adjacentes auxdites aires dopées en n.

2. Détecteur de bandes selon la revendication 1,
**caractérisé en ce que** ladite rupture dans ladite couche isolante est centralement disposée au-dessus de ladite aire intermédiaire d'une façon, que ladite couche isolante interrompue recouvre des zones latérales de ladite aire intermédiaire.

3. Détecteur de bandes selon les revendications 1 et 2,
**caractérisé en ce qu'**au moins une lame de métal est raccordée aux aires dopées en n moyennant un contact.

4. Détecteur de bandes selon une quelconque des revendications 1 à 3,
**caractérisé en ce qu'**au moins une lame de métal est isolée des aires dopées en n moyennant au moins une desdites couches isolantes.

5. Détecteur de bandes selon une quelconque des revendications 1 à 4,
**caractérisé en ce que** la concentration du dope type p dans les aires isolantes directement adjacentes auxdites aires dopée en n est également présente dans des aires dopées en n, pendant qu'elle est surcompensée, cependant, par la plus haute concentration du dope type n.

6. Détecteur de bandes selon une quelconque des revendications 1 à 5,
**caractérisé en ce que** ladite première couche isolante consiste en oxyde de silicium.

7. Détecteur de bandes selon une quelconque des revendications 1 à 5,
**caractérisé en ce qu'**au moins une desdites couches isolantes additionnelles consiste en un matériau différent du matériau de ladite première couche isolante, de préférence en nitrure de silicium.

8. Procédé de fabrication d'un détecteur de bandes selon la revendication 1,
**caractérisé par** les opérations suivantes:
- produire une couche en oxyde d'isolation électrique (3) sur un substrat en silicium surface,
- introduire des atomes du dope type n dans la surface dudit substrat en silicium par implantation d'ions afin de former lesdites aires (1) dopées en n, espacées l'une de l'autre,
- dépôt d'une deuxième couche d'isolation électrique (6) sur toute la surface sur ladite couche en oxyde,
- enlevage local de ladite deuxième couche d'isolation électrique aux points entre des aires dopées en n, ainsi que sur des aires dopées en n, qui servent en tant que des aires d'amenée de tension,
- implantation homogène à grande surface par emploi des atomes du dope type p,
- enlevage local de ladite couche en oxyde aux aires dopées en n, qui servent en tant que des aires d'amenée de tension,
- métallisation homogène sur toute la surface, et
- structurer ladite couche métallique afin de former des lames de métal.

9. Procédé selon la revendication 8,
**caractérisé en ce que** ladite couche en oxyde est formée par oxydation thermique.

10. Procédé selon la revendication 8 ou 9,
**caractérisé en ce que** lesdites aires dopées en n sont dopées en phosphore, en employant un masque.

11. Procédé selon une quelconque des revendications 8 à 10,
**caractérisé en ce que** ladite deuxième couche d'isolation électrique consiste en nitrure de silicium.

12. Procédé selon une quelconque des revendications 8 à 11,
**caractérisé en ce que** ledit enlevage de ladite deuxième couche d'isolation électrique est réalisé moyennant une technique de gravure, en utilisant un masque.

13. Procédé selon une quelconque des revendications 8 à 12,
**caractérisé en ce que** ladite opération de métallisation se fait moyennant de l'aluminium.

14. Procédé selon une quelconque des revendications 8 à 13,
**caractérisé en ce que** ladite opération à structurer ladite couche métallique se fait moyennant une technique de gravure, en utilisant un masque.
